# EUROPÄISCHE PATENTSCHRIFT

(11) **EP 1 524 889 B1**
(45) Veröffentlichungstag und Bekanntmachung des Hinweises auf die Patenterteilung: **07.03.2007**
(21) Anmeldenummer: 03023213.6
(22) Anmeldetag: 13.10.2003
(51) Int. Cl.: H05K 7/14, H02B 1/052

(54) **Befestigung von austauschbaren Terminal- oder Elektronikmodulen mit integrierter Zwangsabschaltung**
Fastening device of replaceable terminal or electronic modules with integrated quick disconnnecting system
Fixation de terminaux ou de modules électroniques échangeables pourvu d'un systéme de déconnexion brusque intégré

(43) Veröffentlichungstag der Anmeldung: 20.04.2005
(73) Patentinhaber: SIEMENS AKTIENGESELLSCHAFT, 80333 München (DE)
(72) Erfinder: Brada, Ralf, 99625 Kölleda (DE); Bräunlich, Michael, 09117 Chemnitz (DE); Deinhardt, Günther, 92224 Amberg (DE); Schirbl, Reinhard, 92421 Schwandorf (DE)

(56) Entgegenhaltungen:
- EP-A- 0 357 308
- EP-A- 0 599 551
- DE-A- 2 510 807
- US-A- 4 869 681
- PATENT ABSTRACTS OF JAPAN vol. 1995, no. 11, 26. Dezember 1995 (1995-12-26) & JP 07 222330 A (YAZAKI CORP), 18. August 1995 (1995-08-18)

## Beschreibung

Die Erfindung betrifft eine Baugruppe, ein Terminalmodul sowie ein Stecksystem zur sicherheitstechnischen Verriegelung der Baugruppe an dem Terminalmodul mittels eines verschiebbaren Riegels.

Elektrische Anlagen, Geräte und Betriebsmittel werden, um sie besser an die Erfordernisse des Anwenders anpassen zu können, oft modular aufgebaut. Ist das modular aufgebaute Gerät eine elektrische Steuerung, wird eine sinnvolle Modularität zumeist mit einer Aufteilung in passive (nicht störanfällige) Terminalmodule und aktive (daher auch störanfällige) Baugruppen bzw. Elektronikmodule erreicht. Durch eine Aneinanderreihung mehrerer Terminal- und Elektronikmodule wird letztlich die vom Kunden gewünschte Funktion der Steuerung erreicht.

Um einen ungestörten Betrieb gewährleisten zu können, müssen die störanfälligen Baugruppen bzw. Elektronikmodule auch unter Last austauschbar und montierbar sein. Die Anlage bzw. Teile der Anlage werden vor dem Wechsel der Baugruppen bzw. Elektronikmodule (im Folgenden zusammengefasst als Baugruppe) also nicht abgeschaltet. Ist aber eine elektrische Baugruppe beispielsweise über einen Stromkreis so mit einen Terminalmodul verbunden, dass beim Stecken oder Ziehen der elektrischen Baugruppe eine Funkenbildung am Steckverbinder zwischen der elektrischen Baugruppe und dem Terminalmodul nicht ausgeschlossen werden kann, so sind besondere konstruktive Maßnahmen vorzusehen, die eine derartige Funkenbildung verhindern.

Eine Möglichkeit besteht darin, die Verriegelung der elektrischen Baugruppe auf dem Terminalmodul so auszulegen, dass beim Betätigen des Verriegelungsmechanismus zwangsläufig eine interne Abschaltung der Baugruppe erfolgt. Hierbei muss gleichzeitig gewährleistet sein, dass in der Zeit zwischen der internen elektrischen Abschaltung und dem Lösen der elektrischen Baugruppe genügend Zeit vergeht, um noch in Kapazitäten oder Induktivitäten gespeicherte Energien sicher abzubauen. Beim Stecken der elektrischen Baugruppe muss dieser Mechanismus umgekehrt funktionieren, d.h. das interne Zuschalten der Baugruppe darf erst nach Abschluss des Steckvorganges möglich sein.

Aus EP-357308 ist eine Verriegelung für Flachbaugruppen bekannt, die ein Austausch der Baugruppe unter Last verhindert, damit eine Funkenbildung ausgeschlossen ist. Die Verriegelung geschieht hierbei über einen Hebel, der die Baugruppe von innen verriegelt. Gleichzeitig wird eine verschiebbare Abdeckung freigegeben, die ein Einschalten der Baugruppe über einen Schalter erlaubt.

Aus der unveröffentlichten Anmeldung beim DPMA mit dem Aktenzeichen 103 302 60.3 ist ein sicherheitstechnischer Verriegelungsmechanismus für elektrische Baugruppen mittels eine Riegels bekannt, bei dem der elektrische Kontakt während des Steckens und Ziehens zwangsläufig geöffnet wird.

Die Aufgabe der vorliegenden Erfindung ist, einen verbesserten Verriegelungsmechanismus für elektrische Baugruppen anzugeben, bei dem eine elektronische Zwangsabschaltung erfolgt.

Die Aufgabe wird gelöst durch eine elektrische Baugruppe zum Einschwenken in ein Terminalmodul, mit einem verschiebbaren Riegel zur Befestigung der Baugruppe am Terminalmodul, wobei der Riegel an einem Ende ein zur Schiebrichtung im wesentlichen senkrecht angeordnetes krallenförmiges Element aufweist, wobei das krallenförmige Element beim Einschwenken der elektrischen Baugruppe zum Untergreifen unter einen Schaltnocken am Terminalmodul vorgesehen ist.

Der Erfindung liegt die Erkenntnis zugrunde, dass ein möglichst einfaches Einstecken und Ziehen bzw. Ein- und Aufschwenken einer elektrischen Baugruppe auf ein Terminalmodul gewährleistet sein sollte. Im montierten Zustand sollte hierbei eine kraftschlüssige Verbindung zwischen Baugruppe und Terminalmodul gewährleistet sein, so dass eine sichere Befestigung der elektrischen Baugruppe garantiert ist. Gleichzeitig sollte die elektronische Baugruppe relativ einfach und zügig demontiert werden können.

In der vorliegenden Erfindung werden diese Anforderungen dadurch vorteilhaft gelöst, dass ein verschiebbarer Riegel, der an der elektrischen Baugruppe angebracht ist, mit einem krallenförmigen Element unter einen Schaltnocken des entsprechenden Terminalmoduls, auf den die Baugruppe aufgeschwenkt wird, untergreift. Hierdurch wird die Baugruppe in ihrer Position fixiert und eine Bewegung der Baugruppe wird verhindert. Gleichzeitig ist ein einfaches Loslösen der Baugruppe möglich, da ein Verschieben des Riegels um eine relativ geringe Strecke ein Herausgleiten der Kralle unter dem Schaltnocken ermöglicht. Anschließend kann die Baugruppe auf einfache Weise abgeschwenkt werden.

Eine weitere vorteilhafte Ausbildung der Erfindung ist dadurch gekennzeichnet, dass der Riegel bei eingeschwenktem Zustand parallel zu einem Steckschlitz des Terminalmoduls angeordnet ist. Durch die parallele Anordnung des Riegels zum Steckschlitz ist eine relativ einfache Konstruktion des Riegelelements möglich. Gleichzeitig wird eine besonders gute Befestigung über die Kralle und den Schaltnocken erzielt, da der Zug durch den Riegel parallel zum Steckschlitz und somit senkrecht zur Baugruppe erfolgt. Die Baugruppe wird durch die Position des Riegels somit über die gesamte Länge des Steckschlitzes kraftschlüssig mit dem Terminalmodul verbunden.

Eine weitere vorteilhafte Ausbildung der Erfindung ist dadurch gekennzeichnet, dass zur Verstärkung der Befestigung durch den Riegel eine Druckfeder vorgesehen ist, wobei die Druckfeder zur Ausübung einer Kraft auf den Riegel derart vorgesehen ist, dass das krallenförmige Element kraftschlüssig an den Schaltnocken gepresst wird. Durch die Druckfeder wird der Riegel quasi in die dem krallenförmigen Element entgegengesetzte Richtung gepresst. Dadurch wird das krallenförmige Element, wenn es einmal in der endgültigen Position nach dem Einschwenken unter den Schaltnocken gegriffen hat, in Richtung des Schaltnockens gezogen. Die Verbindung zwischen Schaltnocken und krallenförmigem Element wird dadurch noch einmal verstärkt. Ein besserer Halt der elektrischen Baugruppe am Terminalmodul wird dadurch gewährleistet.

Eine weitere vorteilhafte Ausbildung der Erfindung ist dadurch gekennzeichnet, dass das krallenförmige Element einen oder mehrere Finger aufweist, wobei der bzw. die Finger distal in Richtung des dem krallenförmigen Element gegenüberliegenden Ende des Riegels gebogen ist bzw. gebogen sind. Hierdurch gibt sich die Möglichkeit, dass das krallenförmige Element noch besser unter den Schaltnocken greifen kann. Der Schaltnocken hat am basalen Ende entsprechende Aussparungen, unter die die hochgebogenen Finger des krallenförmigen Elements greifen können. Ist beim Einschwenken der Baugruppe das krallenförmige Element unter dem Schaltnocken entlang geglitten und anschließend in seiner endgültigen Position nach dem Einschwenken, so greifen die umgebogenen Finger des krallenförmigen Elements in die basalen Aussparungen des Schaltnockens und ein versehentliches Abgleiten des krallenförmigen Elements mit dem Riegel und mit der gesamten elektrischen Baugruppe wird verhindert. Die gebogenen Finger garantieren ein Einrasten in der endgültigen Position. Speziell in Verbindung mit der Druckfeder, die den Riegel entgegen der Bewegung, die beim Einschwenken erfolgt wieder zurückpresst, ist die vorteilhafte Ausbildung der gebogenen Finger von besonderer Bedeutung, da eine kraft- und formschlüssige und somit besonders sichere Verbindung von Baugruppe und Terminalmodul gegeben ist.

Ein seitliches Verschieben der Baugruppe kann dadurch unterbunden werden, dass das krallenförmige Element mehrere Finger aufweist, die an bestimmten Aussparungen des Schaltnockens einrasten müssen. Sind zwischen den Fingern am Schaltnocken entsprechende Ausstülpungen, so können die Finger und damit der Riegel und damit die elektrische Baugruppe nur eine ganz bestimmte Position einnehmen, welches zu einer wesentlich besseren Fixierung der elektrischen Baugruppe führt.

Eine weitere vorteilhafte Ausbildung der Erfindung ist dadurch gekennzeichnet, dass der Riegel Kontaktelemente zum Schalten einer Stromversorgung für die Baugruppe aufweist. Die Schaltung der Stromversorgung erfolgt durch diese vorteilhafte Ausbildung der Erfindung erst bei Bewegen des Riegels bzw. erst wenn die Baugruppe vollständig auf- bzw. eingeschwenkt ist. Eine frühzeitige Stromversorgung beim Einschwenken bzw. eine noch existierende Stromversorgung beim Ziehen oder Ausschwenken der Baugruppe wird hierdurch verhindert. Eine Funkenbildung beim Wechseln der Baugruppe, wie sie in sicherheitsrelevanten Bereichen verhindert werden muss, unterbleibt durch diese mögliche Ausbildung.

Eine weitere vorteilhaften Ausbildung der Erfindung ist dadurch gekennzeichnet, dass die Kontaktelemente zur Schaltung eines und/oder mehrerer eigensicher Hilfsstromkreise auf der Baugruppe vorgesehen sind, wobei über den/die Hilfsstromkreise eine elektrische Trennung eines kritischen internen Stromkreises vorgesehen ist. Die zweikreisige Implementierung der Schaltung der Stromversorgung für die elektrische Baugruppe führt zu einer höheren Sicherheit und einer Reduktion der Gefahr durch Funkenbildung. Ein sicheres Wechseln der Baugruppe wird hierdurch ermöglicht.

Eine weitere vorteilhafte Ausbildung der Erfindung ist dadurch gekennzeichnet, dass die Trennung des kritischen internen Stromkreises bei entrastetem Riegel vorgesehen ist und dass die Aktivierung des internen kritischen Stromkreises bei eingerastetem Riegel vorgesehen ist. Durch diese vorteilhafte Ausbildung wird dem Monteur der Baugruppe auf einfache Weise signalisiert, wann die Baugruppe mit Spannung versorgt wird und somit in einem arbeitsfähigen Status ist bzw. wann die Baugruppe ohne interne Stromversorgung ist und somit gefahrlos gewechselt werden kann.

Eine weitere vorteilhafte Ausbildung der Erfindung ist dadurch gekennzeichnet, dass das Terminalmodul an einem Ende eines Steckschlitzes einen Schaltnocken zum Untergreifen eines krallenförmigen Elements eines Riegels der Baugruppe aufweist. Hierdurch kann auf einfache Weise am Terminalmodul eine Befestigung einer Baugruppe realisiert werden, die eine kraftschlüssige Verbindung zwischen Baugruppe und Terminalmodul gewährleistet und mechanisch einfach zu realisieren ist.

Eine weitere vorteilhafte Ausbildung der Erfindung ist dadurch gekennzeichnet, dass der Schaltnocken an seiner Basis eine oder mehrere Aussparungen zur formschlüssigen Verbindung mit distal gebogenen Fingern des krallenförmigen Elements der Baugruppe aufweist. Ist das krallenförmige Element der Baugruppe einmal unter dem Schaltnocken eingerastet, so verhindern der bzw. die nach oben gebogenen Finger, die in die entsprechenden Aussparungen des Schaltnockens greifen, ein Abgleiten der Baugruppe. Dies ist besonders vorteilhaft, wenn mehrere Aussparungen am Schaltnocken vorgesehen sind, so dass einzelne Finger in einzelne Aussparungen greifen können, und somit eine seitliche Bewegung der Baugruppe in eingeschwenktem Zustand zusätzlich verhindert wird. Ein optimales Einrasten der Baugruppe wird hierdurch gewährleistet.

Eine weitere vorteilhafte Ausbildung der Erfindung ist dadurch gekennzeichnet, dass der Schaltnocken distal abgerundet und/oder abgeschrägt ausgebildet ist. Die Bewegung, mit der die Kralle unter den Schaltnocken gleitet und damit auch die Bewegung des Riegels und der am Riegel sitzenden Kontaktelemente kann durch unterschiedliche Ausbildungen des Schaltnockens unterschiedlich gestaltet werden. Die für ein sicheres Ziehen und Stecken bzw. Ein- und Ausschwenken der Baugruppe notwendige zeitliche und räumliche Positionsabfolge des elektrischen Kontakts am Riegel wird somit durch die Möglichkeit, den Schaltweg durch die Form des Schaltnockens zu verändern, gestaltbar. Ein optimaler Schaltweg und damit eine optimale zeitliche und räumliche Positionsabfolge des elektrische Kontakts kann hierdurch erzielt werden.

Im folgenden wird die Erfindung anhand der in den Figuren dargestellten Ausführungsbeispiele näher beschrieben und erläutert. Es zeigen:
- FIG 1: eine elektrische Baugruppe zum Aufschwenken auf ein Terminalmodul,
- FIG 2: eine beispielhafte Ausgestaltung des Riegels zur Befestigung der Baugruppe,
- FIG 3: ein Schaltdiagramm zur Wiedergabe des Schaltwegs sowie der Schaltposition.

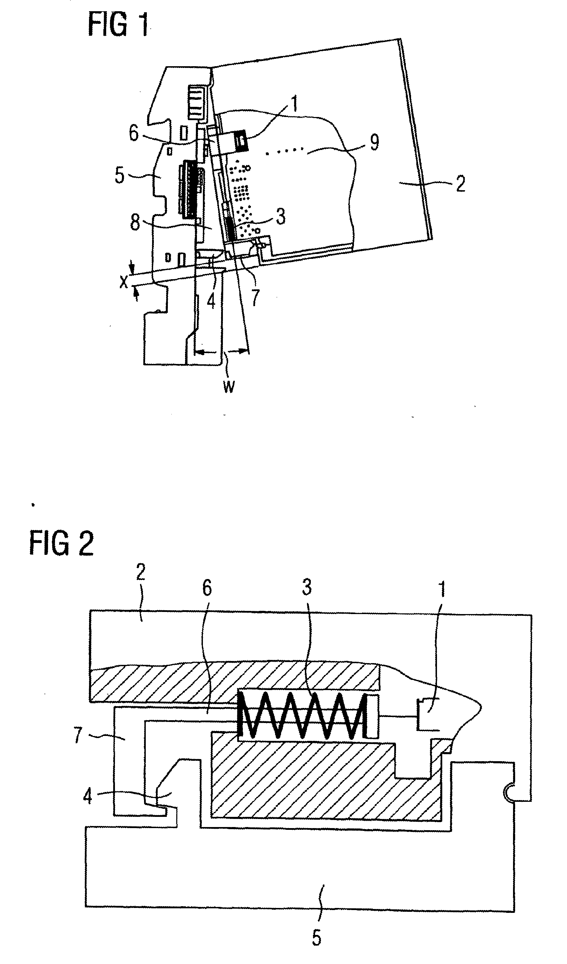

FIG 1 zeigt eine elektronische Baugruppe bzw. ein Elektronikmodul 2, welches auf ein Terminalmodul 5 über den Schwenkwinkel w aufgeschwenkt wird. Das Elektronikmodul 2 weist eine Leiterplatte 9 auf. Das Elektronikmodul 2 weist weiterhin einen Riegel 6 auf, der parallel zu einem Steckschlitz 8 am Terminalmodul 5 bewegt werden kann. Der Riegel 6 wird durch eine Druckfeder 3 in einer zur Bewegung X, welche beim Einschwenken durch den Riegel 6 ausgeführt wird, entgegengesetzter Richtung gepresst. An einem Ende weist der Riegel 6 ein krallenförmiges Element 7 auf. Das krallenförmige Element 7 greift unter einen Schaltnocken 4, welcher am Terminalmodul 5 angebracht ist. Der Riegel 6 weist weiterhin ein Kontaktelement 1 auf, welches in eingeschwenkter Position eine Stromversorgung für die Baugruppe 2 schaltet.

Für einen ungestörten Betrieb können bzw. müssen störanfällige Elektronikmodule bzw. Baugruppen 2 auch unter Last austauschbar und montierbar sein. Im konkreten Fall handelt es sich um eine elektronische Steuerung, die beispielsweise im explosionsgefährdeten Bereich unter Eex-I-Bedingungen eingesetzt wird und deren Elektronikmodule bzw. Baugruppen 2 ohne Abschaltung der Versorgungsspannung montiert und ausgetauscht werden können. Hierbei wird während der Montage, dem Stecken bzw. Einschwenken und der Demontage, dem Ziehen bzw. Abschwenken eines Elektronikmoduls 2 verhindert, dass es an den stromführenden Stiften eines Steckverbinders, welcher das Elektronikmodul 2 mit dem Terminalmodul 5 elektrisch verbindet, zur Entstehung eines Lichtbogens oder Zündfunkens kommen kann. Dazu muss das Elektronikmodul 2 unter Einhaltung von bestimmten Luft- und Kriechstrecken während des Montagevorgangs sicher abgeschaltet werden. Hierzu wird für ein sicheres Ziehen und Stecken des Elektronikmoduls 2 die notwendige zeitliche und räumliche Positionsabfolge des elektrischen Kontakts über das Kontaktelement 1 durch einen radial zur Einschwenkbewegung linear verschiebbaren Riegel 6 zwangsweise über einen Schaltnocken 4 gesteuert.

Beim Aufschwenken der Baugruppe bzw. des Elektronikmoduls 2 auf das Terminalmodul 5 greift die Kralle bzw. das krallenförmige Element 7 des Riegels 6 unter den Schaltnocken 4 des Terminalmoduls 5. Das krallenförmige Element 7 gleitet an der Unterseite des Schaltnockens 4 entlang, während der Riegel 6 eine Bewegung X vollführt. Ist die Baugruppe bzw. das Elektronikmodul 2 in seiner Endposition angelangt, so schnappt das krallenförmige Element 7 unter dem Schaltnocken 4 in eine Einrastposition. In dieser Rastposition wird das Elektronikmodul 2 über den Riegel 6 kraft- und formschlüssig mit dem Terminalmodul 5 verbunden. Die notwendigen Arretierungskräfte werden mit einer Druckfeder 3 erzeugt, welche auch während des Einschwenkvorgangs für eine definierte Position des Riegels 6 sorgt.

FIG 2 zeigt eine Detaildarstellung einer beispielhaften Ausgestaltung des Riegels 6 mit Kontaktelementen 1 und einer Druckfeder 3 sowie einem krallenförmigen Element 7. Das krallenförmige Element 7 greift unter den entsprechenden Schaltnocken 4 am Terminalmodul 5. Das krallenförmige Element 7 hat in der beispielhaften Ausführungsform einen distal nach oben gebogenen Finger, der in entsprechende Aussparung am basalen Ende des Schaltnockens 4 greift. Es ist auch möglich, das krallenförmige Element 7 mit mehreren mehr oder weniger parallel angeordneten Fingern auszugestalten, die jeweils in einzelne Aussparungen unter dem Schaltnocken 4 greifen. Die Länge des bzw. der Finger ist ebenfalls nicht vorgegeben. Bei mehreren Fingern kann eine Trennung der Finger relativ spät, also beispielsweise erst an dem Punkt erfolgen, an dem die Finger nach oben umbiegen. Die Trennung der Finger kann jedoch auch früher erfolgen, also beispielsweise an der Stelle des krallenförmigen Elements 7, die in vollständig eingeschwenkter und eingerasteter Position am abgerundeten bzw. abgeschrägten Ende des Schaltnockens 4 des Terminalmoduls 5 liegt.

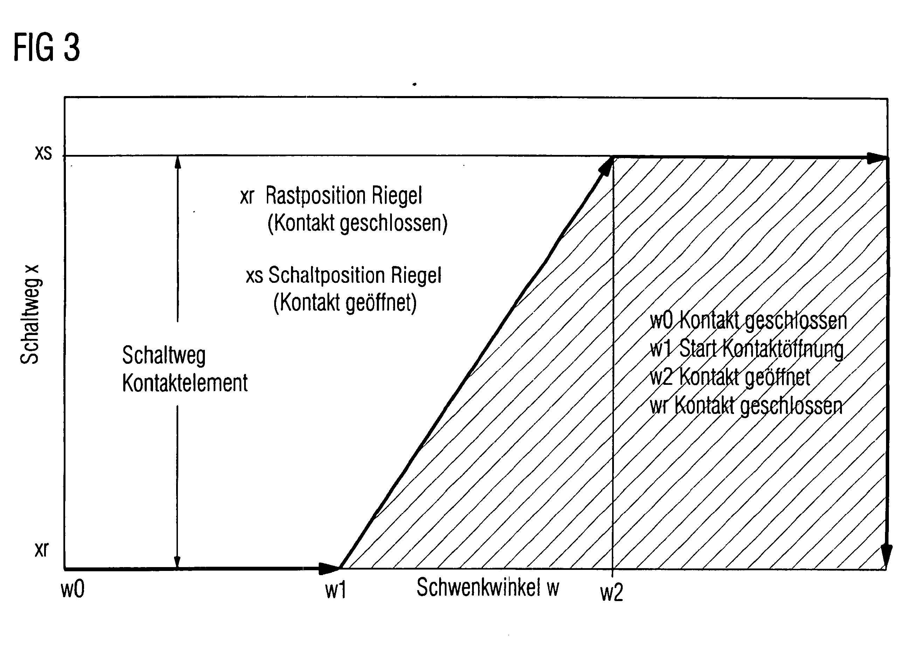

FIG 3 stellt den Schaltweg XS, den Verlauf der Schaltkurve in Abhängigkeit vom Schwenkwinkel W des Elektronikmoduls 2 und den Rastwinkel WR dar. Schaltweg, Verlauf von Schaltkurve und Rastwinkel sind von der geometrischen Form des Schaltnockens 4 abhängig. Sie können somit auf das Kontaktverhalten der stromführenden Stifte des Steckverbinders zwischen Elektronikmodul 2 und Terminalmodul 5 abgestimmt werden. In der Rastposition XR wird das Elektronikmodul 2 über den Riegel 6 kraft- und formschlüssig mit dem Terminalmodul 5 verbunden. Die notwendigen Arretierungskräfte werden mit der Druckfeder 3 erzeugt, welche während des Einschwenkvorganges für eine definierte Position des Riegels 6 sorgt. Auf die sicherheitstechnischen Funktionen des Riegels 6 und damit auch auf die des elektrischen Kontaktes hat die Druckfeder 3 keinen Einfluss.

Im folgenden wird kurz der Funktionsablauf in Abhängigkeit vom Schwenkwinkel w des Elektronikmoduls 2 beim Stecken beschrieben:

| Schwenkwinkel | Funktionsablauf/-weise |
|---|---|
| w0 bis w1 | Der Schalter im Elektronikmodul 2 ist geschlossen und der Riegel 6 befindet sich in der Raststellung xr. Der Schalter besteht aus federnden Laschen am Kontaktelement 1 und entsprechenden Kontaktflächen auf der Leiterplatte 9. |
| | |
| w1 bis w2 | Der Riegel 6 wird gegen die Kraft der Druckfeder 3 in Richtung x entlang der durch den Schaltnocken 4 beschriebenen Kurve verschoben. Das Kontaktelement 1 ist mechanisch mit den Riegel 6 verbunden und bewegt sich deshalb ebenfalls linear, d.h. radial zum Schwenkpunkt des Elektronikmoduls, in Richtung x. Dabei wird der Schalter geöffnet. |
| | |
| w2 | Der Schalter im Elektronikmodul ist sicher geöffnet. Zwischen den stromführenden Stiften des Steckverbinders, welcher die elektrische Verbindung zwischen Elektronikmodul 2 und Terminalmodul 5 bildet, sind bei diesen Schwenkwinkel die entsprechenden Kriech- und Luftstrecken noch so groß, dass kein Zündfunke oder Lichtbogen entstehen kann. |
| | |
| w2 bis wr | Der Schalter im Elektronikmodul 2 bleibt geöffnet. Alle Stiftkontakte des Steckverbinders werden eingeführt. |
| | |
| wr | Der Riegel 6 wird durch die Kraft der Druckfeder 3 entgegengesetzt zur Richtung x bewegt. Terminalmodul 5 und Elektronikmodul 2 werden über den Riegel 6 kraft- und formschlüssig verbunden. Der Schalter im Elektronikmodul 2 wird geschlossen. Das Elektronikmodul ist betriebsbereit. |

Beim Ziehen des Elektronikmoduls läuft der beschriebene Funktionsablauf in umgekehrter Reihenfolge ab. Der Riegel 6 wird mittels eines Werkzeuges (z.B. Schraubenzieher) aus der Raststellung xr in die Schaltstellung xs gezogen.

Die Erfindung betrifft zusammenfassend eine Baugruppe, ein Terminalmodul sowie ein Stecksystem zur sicherheitstechnischen Verriegelung der Baugruppe an dem Terminalmodul. Die Baugruppe wird auf das Terminalmodul aufgeschwenkt. Die Baugruppe verfügt über einen verschiebbaren Riegel zur Befestigung am Terminalmodul. Der Riegel weist an einem Ende ein krallenförmiges Element auf, welches beim Einschwenken der elektrischen Baugruppe zum Untergreifen unter einen Schaltnocken am Terminalmodul vorgesehen ist.

## Patentansprüche

1. Elektrische Baugruppe zum Einschwenken in ein Terminalmodul (5), mit einem verschiebbaren Riegel (6) zur Befestigung der Baugruppe (2) am Terminalmodul (5),
wobei der Riegel (6) an einem Ende ein zur Schiebrichtung im wesentlichen senkrecht angeordnetes krallenförmiges Element (7) aufweist, wobei das krallenförmige Element (7) beim Einschwenken der elektrischen Baugruppe (2) zum Untergreifen unter einen Schaltnocken (4) am Terminalmodul (5) vorgesehen ist, wobei der Riegel (6) Kontaktelemente (1) zum Schalten einer Stromversorgung für die Baugruppe (2) aufweist, wobei die Kontaktelemente (1) zur Schaltung eines und/oder mehrerer eigensicherer Hilfsstromkreise auf der Baugruppe (1) vorgesehen sind, wobei über den/die Hilfsstromkreise eine elektrische Trennung eines kritischen internen Stromkreises vorgesehen ist und wobei die Trennung des internen kritischen Stromkreises bei entrastetem Riegel (6) vorgesehen ist und die Aktivierung des internen kritischen Stromkreises bei eingerastetem Riegel (6) vorgesehen ist.

2. Elektrische Baugruppe nach Anspruch 1,
**dadurch gekennzeichnet,**
**dass** der Riegel (6) in eingeschwenktem Zustand parallel zu einem Steckschlitz (8) des Terminalmoduls (5) angeordnet ist.

3. Elektrische Baugruppe nach Anspruch 1 oder 2,
**dadurch gekennzeichnet,**
**dass** zur Verstärkung der Befestigung durch den Riegel (6) eine Druckfeder (3) vorgesehen ist, wobei die Druckfeder zur Ausübung einer Kraft auf den Riegel (6) derart vorgesehen ist, dass das krallenförmige Element (7) kraftschlüssig an den Schaltnocken (4) gepresst wird.

4. Elektrische Baugruppe nach einem der Ansprüche 1 bis 3,
**dadurch gekennzeichnet,**
**dass** das krallenförmige Element (7) einen oder mehrere Finger aufweist, wobei der bzw. die Finger distal in Richtung des dem krallenförmigen Element (7) gegenüberliegenden Ende des Riegels (6) gebogen ist bzw. gebogen sind.

5. Terminalmodul zur Aufnahme einer elektrischen Baugruppe nach einem der Ansprüche 1 bis 4,
**dadurch gekennzeichnet,**
**dass** das Terminalmodul (5) an einem Ende eines Steckschlitzes (8) einen Schaltnocken (4) zum Untergreifen eines krallenförmigen Elements (7) eines Riegels (6) der Baugruppe (1) aufweist.

6. Terminalmodul nach Anspruch 5,
**dadurch gekennzeichnet,**
**dass** der Schaltnocken (4) an seiner Basis eine oder mehrere Aussparungen zur formschlüssigen Verbindung mit distal gebogenen Fingern des krallenförmigen Elements (7) der Baugruppe aufweist.

7. Terminalmodul nach Anspruch 5 oder 6,
**dadurch gekennzeichnet,**
**dass** der Schaltnocken distal abgerundet und/oder abgeschrägt ausgebildet ist.

8. Stecksystem mit einer elektrischen Baugruppe (2) nach einem der Ansprüche 1 bis 4 und/oder mit einem Terminalmodul (5) nach einem der Ansprüche 5 bis 7.

## Claims

1. Electrical module for pivoting onto a terminal module (5), with a movable latch (6) to fasten the module (2) to the terminal module (5),
with the latch (6) featuring a hook-shaped element (7) at one end arranged essentially at right angles to the direction of movement, with the hook-shaped element (7) being provided to engage below an operating cam (4) on the terminal module (5) when the electrical module (2) is pivoted on, with the latch (6) featuring contact elements (1) for switching a power supply for the module (2), with the contact elements (1) being provided for switching on one and/or a number of intrinsically-safe auxiliary circuits on the module (1), provision being made for electrical isolation of a critical internal circuit, for the isolation of the internal critical circuit when the latch (6) is unlatched, and for activation of the internal critical circuit when the latch (6) is latched.

2. Electrical module in accordance with claim 1,
**characterised in that**
in the module's pivoted-on state the latch (6) is arranged parallel to a plug-in slit (8) of the terminal module (5).

3. Electrical module in accordance with claim 1 or 2,
**characterised in that**
to strengthen the fastening by the latch (6) a compression spring (3) is provided, with the compression spring being provided for exerting a force on the latch (6) such that the hook-shaped element (7) is pressed firmly onto the operating cam (4).

4. Electrical module in accordance with one of the claims 1 to 3,
**characterised in that**
the hook-shaped element (7) features one or more fingers, with the finger or fingers being bent distally in the direction of the end of the latch (6) opposite to the hook-shaped element (7).

5. Terminal module for accommodating an electrical module in accordance with one of the claims 1 to 4,
**characterised in that**
the terminal module (5) features at one end of a plug-in slit (8) an operating cam (4) for engaging with a hook-shaped element (7) of a latch (6) of the module (1).

6. Terminal module in accordance with claim 5,
**characterised in that**
the operating cam (4) features on its base one or more cutouts for positive connection with distally bent fingers of the hook-shaped element (7) of the module.

7. Terminal module in accordance with claim 5 or 6,
**characterised in that**
the operating cam is embodied with distal curvature and/or tapering.

8. Plug-in system with an electrical module (2) in accordance with one of the claims 1 to 4 and/or with a terminal module (5) in accordance with one of the claims 5 to 7.

## Revendications

1. Bloc électrique à basculer dans un module terminal (5), muni d'un verrou (6) mobile pour fixer le bloc (2) sur le module terminal (5) et dans lequel
- à une extrémité le verrou (6) comporte un élément en griffe (7) pratiquement perpendiculaire à la direction de glissement,
- quand on bascule le bloc électrique (2), l'élément en griffe (7) est conçu pour passer sous une came de commutation (4) sur le module terminal (5),
- le verrou (6) comporte des éléments de contact (1) pour raccorder une alimentation électrique destinée au bloc (2),
- les éléments de contact (1) sont prévus pour raccorder un et/ou plusieurs circuits électriques auxiliaires à sécurité intrinsèque sur le bloc (1),
- une séparation électrique d'un circuit électrique interne critique est prévue par l'intermédiaire du ou des circuits électriques auxiliaires et
- la séparation du circuit électrique interne critique est prévue quand le verrou (6) est débloqué et l'activation du circuit électrique interne critique est prévue quand le verrou (6) est bloqué.

2. Bloc électrique selon la revendication 1, **caractérisé en ce que**, à l'état basculé, le verrou (6) est parallèle à une fente d'enfichage (8) du module terminal (5).

3. Bloc électrique selon la revendication 1 ou 2, **caractérisé en ce qu'**un ressort de pression (3) est prévu pour renforcer la fixation à l'aide du verrou (6), pour exercer une force sur le verrou (6) le ressort de pression est alors conçu de telle sorte que l'élément en griffe (7) est poussé contre la came de commutation (4) par combinaison de forces.

4. Bloc électrique selon l'une des revendications 1 à 3, **caractérisé en ce que** l'élément en griffe (7) comporte un ou plusieurs doigts, le ou les doigts étant recourbés distalement en direction de l'extrémité - du verrou (6) - qui fait face à l'élément en griffe (7).

5. Module terminal pour recevoir un bloc électrique selon l'une des revendications 1 à 4, **caractérisé en ce que**, à une extrémité d'une fente d'enfichage (8), le module terminal (5) comporte une came de commutation (4) pour passer sous un élément en griffe (7) d'un verrou (6) du bloc (1).

6. Module terminal selon la revendication 5, **caractérisé en ce que**, à sa base, la came de commutation (4) comporte un ou plusieurs creux pour assurer la liaison par combinaison de formes avec des doigts recourbés distalement de l'élément en griffe (7) du bloc.

7. Module terminal selon la revendication 5 ou 6, **caractérisé en ce que** la came de commutation est arrondie ou biseautée.

8. Système d'enfichage comportant un bloc électrique (2) selon l'une des revendications 1 à 4 et/ou un module terminal (5) selon l'une des revendications 5 à 7.
